# EUROPÄISCHE PATENTSCHRIFT

(11) **EP 1 621 342 B1**
(45) Veröffentlichungstag und Bekanntmachung des Hinweises auf die Patenterteilung: **11.04.2007**
(21) Anmeldenummer: 05015017.6
(22) Anmeldetag: 11.07.2005
(51) Int. Cl.: B41C 1/14

(54) **Verfahren zum Einbringen von Durchbrechungen in ein Substrat**
Process for perforating a substrate
Procédé pour la perforation d'un support

(30) Priorität: 28.07.2004 DE 102004036662
(43) Veröffentlichungstag der Anmeldung: 01.02.2006
(73) Patentinhaber: LPKF Laser & Electronics Aktiengesellschaft, 30827 Garbsen (DE)
(72) Erfinder: Wenke, Stephan, 31535 Neustadt a. Rbg. (DE)
(74) Vertreter: Scheffler, Jörg

(56) Entgegenhaltungen:
- GB-A- 2 276 589
- US-A- 5 444 212
- US-A- 5 822 209
- PATENT ABSTRACTS OF JAPAN Bd. 016, Nr. 335 (M-1283), 21. Juli 1992 (1992-07-21) & JP 04 099626 A (ISHIZAKA SHIYOUJI KK), 31. März 1992 (1992-03-31)

## Beschreibung

Die Erfindung betrifft ein Verfahren zum Einbringen von Durchbrechungen mit einer vorbestimmten Position in ein Substrat, insbesondere zur Herstellung von Schablonen oder Masken mittels eines Lasers, bei dem das Substrat mittels eines insbesondere als Spannrahmen ausgeführten Fixiermittels während der Bearbeitung positioniert ist, bei dem zunächst Koordinaten eines Bezugspunktes in einem zentralen Bereich, der zu den Fixiermitteln beabstandet ist, bestimmt werden, anschließend der Abstand der jeweiligen vorbestimmten Position der Durchbrechungen von diesem Bezugspunkt ermittelt wird und schließlich daraus eine Rangfolge der Abstände der Durchbrechungen von dem Bezugspunkt bestimmt und einem Bearbeitungsprogramm für die Abfolge beim Einbringen der Durchbrechungen zugrunde gelegt wird, wobei dem Bearbeitungsprogramm eine richtungsabhängige Material schwächung des Substrates infolge örtlich kumulierter Durchbrechungen als korrekturwert zugrunde gelegt wird.

Ein Verfahren zum Einbringen von Durchbrechungen mit einer vorbestimmten Position in ein Substrat, insbesondere als Druckschablone wird in der Praxis bereits vielfach beispielsweise bei der Fertigung von elektronischen Baugruppen mit SMT-Bauelementen eingesetzt. Vor der Bestückung dieser Bauelemente wird Lotpaste im Siebdruckverfahren durch die Durchbrechungen des Substrates auf Anschlusspads einer Leiterplatte gedrückt.

Voraussetzung für die Durchführung des Siebdruckverfahrens sind formstabile Druckschab-Ionen, die heute meist aus Stahl oder aus Nickel, seltener aus Polyimid, gefertigt werden. Die Materialstärke des die Druckschablone bildenden Substrates definiert beim Siebdruck die gedruckte Lotpastenhöhe.

Neben der klassischen SMT-Fertigung finden Siebdruckverfahren mit Druckschablonen unter anderem auch Anwendung bei der Herstellung von Wafern, hochpoligen Chipgehäusen, keramischen Multilayern, FlipChips und OLED's (organic light emitting diodes).

Ein weiterer bedeutender Anwendungsbereich solcher Schablonen oder Masken betrifft den Einsatz bei Sputter- oder Bedampfungsverfahren.

Für ein optimales Druckergebnis werden hohe Anforderungen an die Druckschablone hinsichtlich Präzision und Reproduzierbarkeit der Position und der Abmessungen der einzubringenden Durchbrechungen sowie einer gleichmäßigen Spannungsverteilung über die gesamte Fläche der Druckschablone gestellt.

Als problematisch erweist sich in der Praxis die mit dem Einbringen der Durchbrechungen in das Substrat einhergehende Materialschwächung, die zu einem insgesamt veränderten Spannungszustand des mittels des Spannrahmens fixierten Substrates führt. Diese Veränderung des Spannungszustandes verursacht eine unerwünschte Positionsabweichung, insbesondere eine Verschiebung der bereits zuvor eingebrachten Durchbrechungen relativ zu dem Spannrahmen sowie auch zu nachfolgend einzubringenden Durchbrechungen.

In der Praxis werden daher oftmals zunächst in einem ersten Arbeitsgang alle gewünschten Durchbrechungen in der vorbestimmten Position, jedoch zunächst mit reduzierten Abmessungen eingebracht. In einem zweiten Arbeitsgang werden die Durchbrechungen dann auf die jeweilige Soll-Abmessung vergrößert. Hierdurch können die nach dem ersten Arbeitsgang eintretenden Verlagerungen in dem zweiten Arbeitsgang ausgeglichen werden. Als nachteilig erweist sich dabei der zusätzliche zeitliche Aufwand für den zweiten Arbeitsgang.

Es ist auch bereits daran gedacht worden, den sich verändernden Spannungszustand mittels eines rechnerinternen Modells vorherzubestimmen und daraus Korrekturgrößeren abzuleiten, die in die Positionsbestimmung beim Einbringen der Durchbrechungen einfließen. Dieser Gedanke hat sich jedoch als sehr aufwendig und als wirtschaftlich wenig erfolg versprechend herausgestellt.

Durch die DE 100 34 648 B4 ist auch ein Verfahren zur Herstellung einer Druckschablone bekannt, bei dem eine Metallschablone unmittelbar mit einem vorgespannten Rahmen unlösbar verbunden und anschließend durch Aufhebung der Rahmenvorspannung verspannt wird. Die das Druckmuster bildenden Durchbrechungen können vor oder im Anschluss an die Aufbringung der Metallschablone auf den Rahmen durch Stanzung oder Bohrung in die Metallschablone eingebracht werden. Die Druckschablone ist bei der Leiterplattenbestückung, Baugruppenherstellung oder beim Wafer-Bumping einsetzbar.

Um bei einem Verfahren zum Herstellen von Maskenanordnungen gemäß der DE 101 41 497 A1 systematische Abweichungen von einer Sollanordnung einer auszubildenden Anordnung von Ausnehmungen der Maske weitgehend zu vermeiden, wird das Strukturieren des Maskensubstrats in einer Abfolge von Teilprozessen durchgeführt, wobei die Teilprozesse derart aufeinander abgestimmt werden, dass sich die aus diesen ausbildenden Abweichungen kompensieren, so dass dadurch eine Fehlerkorrektur erreicht wird.

Ferner beschreibt auch die US 2003/0041753 A1 eine mit Durchbrechungen ausgestattete Schablone oder Maske.

Ein gattungsgemäßes Verfahrens ist durch die JP 04 099 626 zur Herstellung von textilen Druckschablonen bekannt, bei dem ein Druckmuster als ein Muster von Durchbrechungen in eine in einem Spannrahmen fixierte Druckschablone mittels eines Lasers eingebracht wird. Hierzu rotiert die Druckschablone um eine zentrale Drehachse, demgegenüber der Laserstrahl radial verlagert wird, so dass sich eine Bearbeitungsbahn auf konzentrischen Kreisen oder in Spiralform ergibt. Daraus folgt, dass der Abstand der gemäß dem Bearbeitungsprogramm durch die Modulation des Lasers eingebrachten Durchbrechungen gegenüber der Drehachse im Verlauf des Prozesses zunimmt.

Der Erfindung liegt die Aufgabe zugrunde, ein Verfahren der eingangs genannten Art derart zu verbessern, dass eine örtliche Verlagerung der bereits eingebrachten Durchbrechungen aufgrund nachfolgender Bearbeitungsschritte in einfacher Weise vermieden werden kann.

Diese Aufgabe wird erfindungsgemäß mit einem Verfahren gemäß den Merkmalen des Anspruchs 1 gelöst. Die weitere Ausgestaltung der Erfindung ist den Unteransprüchen zu entnehmen.

Erfindungsgemäß ist also ein Verfahren vorgesehen, bei dem zunächst Koordinaten eines Bezugspunktes in einem zentralen Bereich, der zu den Fixiermitteln beabstandet ist, bestimmt werden, anschließend der Abstand der jeweiligen vorbestimmten Position der Durchbrechungen von diesem Bezugspunkt ermittelt wird und schließlich daraus eine Rangfolge der Abstände der Durchbrechungen von dem Bezugspunkt bestimmt und einem Bearbeitungsprogramm für die Abfolge beim Einbringen der Durchbrechungen zugrunde gelegt wird wobei dem Bearbeitungsprogramm eine richtungsabhängige Materialschwächung des Substrates infolge örtlich kumulierter Durchbrechungen als Korrekturwert zugrunde gelegt wird. In überraschend einfacher Weise wird es dadurch erstmals möglich, aufgrund der entsprechend der Abstände festgelegten Bearbeitungsreihenfolge den Spannungszustand des Substrates auszugleichen oder konstant zu halten und dadurch eine örtliche Verlagerung der zuvor eingebrachten Durchbrechungen aufgrund nachfolgend eingebrachter Durchbrechungen praktisch zu vermeiden. Der Bezugspunkt ist dabei grundsätzlich in einem zentralen Bereich frei wählbar und kann beispielsweise mit dem geometrischen Mittelpunkt zusammenfallen. Der daraus bestimmte Abstand zu den Positionen der nachfolgend einzubringenden Durchbrechungen wird vektoriell ermittelt. Neben der Bearbeitung mittels eines Lasers können auch Strahlschneidverfahren, beispielsweise Wasserstrahlschneidverfahren, sowie spanende Verfahren zum Einbringen der Durchbrechungen eingesetzt werden. Dadurch dass dem Bearbeitungsprogramm eine richtungsabhängige Materialschwächung des Substrates infolge örtlich kumulierter Durchbrechungen als Korrekturwert zugrunde gelegt wird, wird abweichend von der auf dem jeweiligen Abstand der Durchbrechungsposition von dem Bezugspunkt basierenden Reihenfolge bei der Bearbeitung eine unerwünschte Schwächung des Substrates aufgrund einseitig eingebrachter Durchbrechungen vermieden, indem hierzu beispielsweise eine Unterteilung des Substrates in Quadranten oder in Teile davon vorgenommen wird und hierfür jeweils eine Auswertung der Gesamtfläche der eingebrachten Durchbrechungen vorgenommen wird.

Bei einer besonders vorteilhaften Ausgestaltung des Verfahrens wird der Bezugspunkt aufgrund empririsch oder rechnerisch ermittelter Bearbeitungseigenschaften basierend auf bekannten Substrat-Parametern, insbesondere Werkstoff und Abmessungen, bestimmt. Hierdurch können beispielswiese richtungsabhängige Materialeigenschaften des Substrates ebenso berücksichtigt werden wie partielle Materialaufhäufungen. Insbesondere lassen sich dadurch grundsätzlich auch dreidimensional geformte Substrate bearbeiten.

Als Bezugspunkt kann beispielsweise der Flächenschwerpunkt oder das Zentrum des Spannungszustandes bestimmt werden. Eine besonders praxisgerechte Ausführungsform des Verfahrens wird in der Praxis hingegen dann erreicht, wenn als Bezugspunkt der Schwerpunkt der einzubringenden Durchbrechungen bestimmt wird.

Die Durchbrechungen können in der Praxis nahezu beliebige Abmessungen und Geometrien aufweisen. Besonders zweckmäßig ist hingegen eine Ausgestaltung des Verfahrens, bei dem die Durchbrechungen mit einem übereinstimmenden Flächeninhalt eingebracht werden. Hierdurch können abweichende Einflüsse auf den Spannungszustand aufgrund unterschiedlicher Abmessungen oder Geometrien vermieden werden. Sofern solche abweichenden Abmessungen oder Geometrien erforderlich sind, werden diese aus einzelnen übereinstimmenden Durchbrechungen zusammengesetzt.

Eine besonders vorteilhafte Ausgestaltung des Verfahrens wird auch dann erreicht, wenn das Bearbeitungsprogramm mit dem Einbringen der den geringsten Abstand zu dem Bezugspunkt aufweisenden Durchbrechung beginnt und daher der mittlere Bereich des Substrates zuerst bearbeitet wird. Die dort eingebrachten Durchbrechungen führen erfahrungsgemäß zu der geringesten Veränderung des Spannungszustandes.

Die Bearbeitung kann ausgehend von dem Bezugspunkt sternförmig erfolgen. Besonders vorteilhaft ist es hingegen, wenn die Bearbeitung auf einer um den Bezugspunkt umlaufenden Bewegungsbahn insbesondere spiralförmig erfolgt, um dadurch die Bearbeitungsdauer aufgrund der optimierten Bewegungsbahn des Bearbeitungskopfes zu verringern.

Weiterhin erweist es sich als besonders praxis gerecht, wenn dem Bearbeitungsprogramm zusätzlich während der Bearbeitung erfasste Messwerte als Korrekturwert zugrunde gelegt werden. Dabei können beispielsweise Spannungszustände durch entsprechende Parameter, die hierzu dem Fixiermittel zugeordnet sein können, erfasst werden, um einer unerwünschten Veränderung durch eine Korrektur des Bearbeitungsprogrammes entgegenzuwirken.

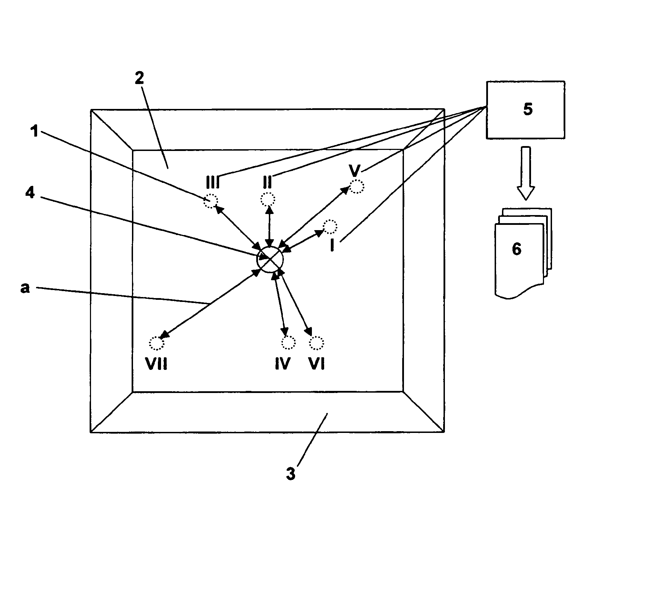

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt in einer Prinzipdarstellung einen Aufbau zum Einbringen von einzelnen Durchbrechungen 1 vorbestimmter Position in ein als Druckschablone ausgeführtes Substrat 2 mittels eines nicht gezeigten Lasers. Das Substrat 2 ist hierzu mittels eines als Spannrahmen ausgeführten Fixiermittels 3 positioniert. Eine örtliche Verlagerung von Durchbrechungen 1 aufgrund des bei nachfolgenden Bearbeitungsschritten veränderten Spannungszustandes des Substrates 2 wird dabei vermieden, indem zunächst die Koordinaten eines zentralen Bezugspunktes 4 bestimmt werden. Der jeweiligen Abstand a der vorbestimmten Positionen der Durchbrechungen 1 von diesem Bezugspunkt 4 wird anschließend bestimmt und daraus eine Rangfolge 5 gebildet. Diese Rangfolge 5 bildet dann die Grundlage für ein Bearbeitungsprogramm 6, durch welches die Bewegungsbahn des Laserkopfes gesteuert und die Durchbrechungen 1 in das Substrat 2 eingebracht werden.

## Patentansprüche

1. Verfahren zum Einbringen von Durchbrechungen mit einer vorbestimmten Position in ein Substrat, insbesondere zur Herstellung von Schablonen oder Masken mittels eines Lasers, bei dem das Substrat mittels eines insbesondere als Spannrahmen ausgeführten Fixiermittels während der Bearbeitung positioniert ist, bei dem zunächst Koordinaten eines Bezugspunktes in einem zentralen Bereich, der zu den Fixiermitteln beabstandet ist, bestimmt werden, anschließend der Abstand der jeweiligen vorbestimmten Position der Durchbrechungen von diesem Bezugspunkt ermittelt wird und schließlich daraus eine Rangfolge der Abstände der Durchbrechungen von dem Bezugspunkt bestimmt und einem Bearbeitungsprogramm für die Abfolge beim Einbringen der Durchbrechungen zugrunde gelegt wird, wobei dem Bearbeitungsprogramm eine richtungsabhängige Materialschwächung des Substrates infolge örtlich kumulierter Durchbrechungen als Korrekturwert zugrunde gelegt wird.

2. Verfahren nach Anspruch 1, **dadurch gekennzeichnet, dass** der Bezugspunkt aufgrund empririsch oder rechnerisch ermittelter Bearbeitungseigenschaften basierend auf bekannten Substrat-Parametern, insbesondere Werkstoff und Abmessungen, bestimmt wird.

3. Verfahren nach den Ansprüchen 1 oder 2, **dadurch gekennzeichnet, dass** als Bezugspunkt der Schwerpunkt der einzubringenden Durchbrechungen bestimmt wird.

4. Verfahren nach zumindest einem der vorhergehenden Ansprüche, **dadurch gekennzeichnet, dass** die Durchbrechungen mit einem übereinstimmenden Flächeninhalt eingebracht werden.

5. Verfahren nach zumindest einem der vorhergehenden Ansprüche, **dadurch gekennzeichnet, dass** das Bearbeitungsprogramm mit dem Einbringen der den geringsten Abstand zu dem Bezugspunkt aufweisenden Durchbrechung beginnt.

6. Verfahren nach zumindest einem der vorhergehenden Ansprüche, **dadurch gekennzeichnet, dass** die Bearbeitung auf einer um den Bezugspunkt umlaufenden Bewegungsbahn insbesondere spiralförmig erfolgt.

7. Verfahren nach zumindest einem der vorhergehenden Ansprüche, **dadurch gekennzeichnet, dass** dem Bearbeitungsprogramm zusätzlich während der Bearbeitung erfasste Messwerte als Korrekturwerte zugrunde gelegt werden.

## Claims

1. Method for forming openings having a predetermined position in a substrate, in particular for producing templates or masks by means of a laser, in which method the substrate is positioned during machining using a fixing means which is, in particular, configured as a tensioning frame, in which method firstly coordinates of a reference point in a central region at a distance from the fixing means are determined, subsequently the distance of the respective predetermined position of the openings from this reference point is ascertained and finally an order of priority of the distances of the openings from the reference point is determined therefrom and is used as a basis for the machining programme for the sequence for forming openings, the machining programme being based on a directional material weakening of the substrate caused by localised accumulation of openings as a correction value.

2. Method according to claim 1, **characterised in that** the reference point is determined on the basis of empirically or computationally ascertained machining characteristics based on known substrate parameters, in particular material and dimensions.

3. Method according to claim 1 or 2, **characterised in that** the centre of gravity of the openings to be formed is determined as the reference point.

4. Method according to at least one of the preceding claims, **characterised in that** the openings are formed with a corresponding area.

5. Method according to at least one of the preceding claims, **characterised in that** the machining programme starts by forming the opening having the smallest distance from the reference point.

6. Method according to at least one of the preceding claims, **characterised in that** the machining occurs on a movement path that revolves around the reference point is, in particular, helical.

7. Method according to at least one of the preceding claims, **characterised in that** the machining programme is also based on measured values as correction values detected during machining.

## Revendications

1. Procédé de réalisation d'ajours ayant une position prédéterminée dans un substrat, en particulier afin de fabriquer des pochoirs ou des masques à l'aide d'un laser, dans lequel le substrat est positionné à l'aide de moyens de fixation configurés en particulier sous la forme d'un cadre de serrage pendant l'usinage, dans lequel on détermine tout d'abord les coordonnées d'un point de référence dans une zone centrale qui est éloignée des moyens de fixation, puis la distance de la position prédéterminée respective des ajours par rapport à ce point de référence est déterminée et enfin, à partir de cela, on détermine un classement des écarts entre les ajours et le point de référence puis on soumet ceci à un programme d'usinage déterminant l'ordre de la réalisation des ajours, moyennant quoi, dans le cadre du programme d'usinage, on se base sur un affaiblissement du matériau du substrat en fonction de la direction suite à des ajours cumulés localement, qui servent de valeurs correctrices.

2. Procédé selon la revendication 1, **caractérisé en ce que** le point de référence est déterminé sur la base des propriétés d'usinage déterminées par voie empirique ou de calcul, en fonction des paramètres du substrat connus, en particulier du matériau et des dimensions.

3. Procédé selon l'une quelconque des revendications 1 ou 2, **caractérisé en ce que**, comme point de référence, on détermine le barycentre des ajours à réaliser.

4. Procédé selon l'une quelconque des revendications précédentes, **caractérisé en ce que** les ajours sont réalisés avec un contenu concordant en termes de surface.

5. Procédé selon l'une quelconque des revendications précédentes, **caractérisé en ce que** le programme d'usinage commence par la réalisation de l'ajour présentant la plus petite distance par rapport au point de référence.

6. Procédé selon l'une quelconque des revendications précédentes, **caractérisé en ce que** l'usinage est réalisé en particulier en spirale sur une trajectoire de déplacement entourant le point de référence.

7. Procédé selon l'une quelconque des revendications précédentes, **caractérisé en ce que** l'on utilise comme base pour le programme d'usinage, en outre, les valeurs de mesure enregistrées durant l'usinage, qui servent de valeurs correctrices.
